# EUROPEAN PATENT APPLICATION

(11) **EP 2 101 335 A1**
(43) Date of publication of application: **16.09.2009**
(21) Application number: 08152551.1
(22) Date of filing: 10.03.2008
(51) Int. Cl.: H01B 1/22, H01B 1/24, B29C 45/00, C08K 7/24, H05K 9/00

(54) **Mouldable material.**

(71) Applicant: Nederlandse Organisatie voor toegepast-natuurwetenschappelijk onderzoek TNO, 2628 VK Delft (NL)
(72) Inventor: Kunen, Joseph Mathias Gerardus, 3123 PN Schiedam (NL); Langeveld, Petrus Cornelis Gerardus, 5658 AS Eindhoven (NL); de Zwart, Renatus Marius, 5655 JP Eindhoven (NL)
(74) Representative: Hatzmann, Martin

(57) **Abstract**

Mouldable material, comprising a mouldable synthetic material, a quantity of fullerenes having an elongated shape, and a metal alloy having a melting temperature of 100-400°C. The quantity of fullerenes preferably comprises nanotubes of any conductive material, e.g. comprise carbon, copper, bismuth, aluminium, boron etc. nanotubes. The metal alloy preferably has a melting range/temperature which is lower than or coincides with the temperature processing range of the synthetic material.

## Description

The present invention refers to a mouldable material. In particular a mouldable material having good conductive properties.

More and more electrical functions tend to be integrated in plastic products. In such so-called "Moulded Interconnect Devices" (MID) conducting structures may be provided on plastic substrates by means of different techniques, such as two-shot moulding [2C-MID], laser techniques [e.g. LDS and MIPTEC], hot embossing [HE-MID], insert moulding [IS-MID]. In those techniques patterning and metallization are subsequent processing steps:
- in 2C-MID [SKW-process, PCK-process, Bayer process] patterning of the structures results from injection moulding, whereas electro-plating yields the metal structures;
- in LDS [LPKF process] and MIPTEC [Panasonic process] a laser performs the patterning step followed by electro-plating of the conducting structures;
- in HE-MID a flexible foil with a metal structure is pressed on a plastic substrate;
- in IS-MID a conductive metal stamped-bended sheet is used as insert in the injection moulded process.

Combinations of the mentioned processes are also known.

Mouldable synthetic materials are commercially available having specific resistances of about 10⁻² Ohm.cm. Those materials are well applicable for shielding and in antennas etc. However, for conducting substantial electrical currents a specific resistance of about 10⁻⁵ will be required.

W02005057590 discloses several metal/plastic hybrid materials comprising additives in plastic and realizing specific resistances of less than 10⁻² Ohm.cm. The metal/plastic mixtures comprise a thermoplastic such as polyamide 6, a metal alloy having a rather low melting temperature, i.e. between 100°C and 400°C, and an electrically conductive and/or metallic filler material, consisting of fibres and/or particles of e.g. copper, steel or carbon, having e.g. a length of about 2 mm and a thickness in the range of 10-80 µm. As a preferred metal alloy W02005057590 proposes a commercially available alloy "MCP 200" manufactured by MCP HEK GmbH in Lübeck, having a melting point of 200°C.

The materials known from W02005057590 may have rather good injection moulding capabilities for rather "bulky" parts. A severe disadvantage, however, is that, due to the dimensions of the conductive particles, in practice, the rheological behaviour does not meet the requirements for the manufacture of small conductive MID parts (including thin conductive channels) e.g. in an "In Mould Assembly" (IMA) production process, in which those product parts (including said conductive channels) are moulded and assembled within the same mould. Increasing the amount of metal filler to decrease the resistance of materials even more makes that disadvantage more pronounced, limiting the application of such materials.

Additionally, in Michaeli and Pfefferkorn, "Material and processing behaviour of thermoplastics filled with low melting metals", Plastics and Rubber Processing and Applications, 2006 Vol. 35, 9 pp 380-386 (http://cat.inist.fr/?aModele=afficheN&cpsidt=18275270), it is stated that polymer blends filled with solid fillers such as metal fibres or carbon black can no longer fulfil the increasing demands on electrical and thermal conductivity. High levels of hard fillers increase the melt viscosity unacceptably, causing a minimised process window, high mechanical stresses on the polymer as well as an increased abrasion on both mould and machinery. The high electrical conductivity required for connectors, moulded interconnect devices (MID) or sensors is said to be achieved by a material developed by IKV, Aachen, and Siemens AG, Erlangen/Germany, combining fibre filled polymer blends with low melting metal alloys. These alloys have the advantage of being already molten during processing and of not solidifying before the cooling phase.

Aim of the present invention thus is to provide an improved material which is well fit for moulding well conductive parts having dimensions of less than 1 mm and, preferably, less than 100 micrometer.

Another aim is to provide a mouldable plastic mixture which meets the requirements for "In Mould Assembly".

Yet another aim is to provide a conductive plastic having good mechanical properties, like tensile strength, flexural strength etc.

According to the invention it is preferred to provide a mouldable material having good conductive properties, comprising:
- a synthetic material,
- nanotubes or other elongated fullerenes,
- and a metal alloy having a (low) melting temperature within or below the range of the processing (i.e. melting) temperature of the synthetic material.

Carbon nanotubes (CNTs) are allotropes of carbon having a nanostructure where the length-to- diameter ratio can exceed 1,000,000. Such cylindrical carbon molecules have novel properties that make them potentially useful in many applications in nanotechnology, electronics, optics and other fields of materials science. They exhibit extraordinary strength and unique electrical properties, and are efficient conductors of heat. Inorganic nanotubes have also been synthesized. Nanotubes are members of the fullerene family, which also includes buckyballs. Whereas buckyballs are spherical in shape, a nanotube is cylindrical, with at least one end typically capped with a hemisphere of the buckyball structure. Their name is derived from their size, since the diameter of a nanotube is in the order of only a few nanometres (nm), while they can be up to several millimeters in length. Nanotubes are categorized as single-walled nanotubes (SWNTs) and multi-walled nanotubes (MWNTs). Nanotubes naturally align themselves into "ropes" held together by Van der Waals forces.

Besides carbon nanotubes, other inorganic nanotubes could be used, e.g. copper or bismuth nanotubes, as presented by Dachi Yang et al, in "Electrochemical synthesis of metal and semimetal nanotube-nanowire heterojunctions and their electronic transport properties", Chem. Commun., 2007, 1733-1735, www.rsc.org/Publishing/Journals/CC/article.asp?doi=b614147a.

Aluminum nanotubes and their manufacture are presented by Dae Dong Sung et al, "A New Fabrication Method of Aluminum Nanotube Using Anodic Porous Alumina Film as a Template", public of the Department of Chemistry, Dong-A University, Busan 604-714, Korea, http://journal.kcsnet.or.kr/main/j_search/j_download.htm?code=B060812.

Moreover, boron nanotubes, as presented by Xiaobao Yang, Yi Ding and Jun Ni in "Ab initio prediction of stable boron sheets and boron nanotubes: Structure, stability, and electronic properties" Phys. Rev. B 77, 041402(R) (2008) (4 pages) (DOI: 10.1103/PhysRevB.77.041402), may be an interesting choice as well.

As the low melting metal alloy, it is preferred to apply an alloy of which the melting point/range is lower than the temperature processing range of the relevant synthetic material, or which coincides with at least part of that range. The MCP 200 alloy (http://www.mcphek.de/pdf/mcp_leg/deutsch.jpg) which is commercially available from MCP HEK GmbH in Lübeck, having a melting point of 200°C, the use of which material as component for mouldable conductor is known as such from W02005057590, might be such an alloy.

The invention may introduce a breakthrough in MID applications.

## Claims

1. Mouldable material, comprising
- a mouldable synthetic material,
- a quantity of fullerenes having an elongated shape, and
- a metal alloy having a melting range/temperature within or below the range of the processing temperature of the synthetic material.

2. Mouldable material according to claim 1, said quantity of fullerenes comprising nanotubes of any suitable material.

3. Mouldable material according to claim 2, said nanotubes being carbon nanotubes.

4. Mouldable material according to claim 2, said nanotubes being inorganic nanotubes.

5. Mouldable material according to claim 4, said nanotubes being metallic nanotubes.

6. Mouldable material according to claim 5, said nanotubes being copper nanotubes.

7. Mouldable material according to claim 5, said nanotubes being aluminum nanotubes.

8. Mouldable material according to claim 5, said nanotubes being bismuth nanotubes.

9. Mouldable material according to claim 1, said nanotubes being boron nanotubes.

10. Mouldable material according to claim 1, said metal alloy comprising the MCP 200 alloy manufactured by MCP HEK GmbH or a mainly similar alloy.

11. Product made by a mouldable material of one or more claims 1-10.
